# EUROPÄISCHE PATENTSCHRIFT

(11) **EP 3 711 462 B1**
(45) Veröffentlichungstag und Bekanntmachung des Hinweises auf die Patenterteilung: **25.01.2023**
(21) Anmeldenummer: 18803408.6
(22) Anmeldetag: 13.11.2018
(51) Int. Cl.: H01R 4/02, H01R 43/02, B23K 20/02, B23K 20/24, H01L 23/00, H05K 3/32, H05K 3/40, H05K 1/09, H05K 3/36, B23K 20/233, B23K 101/38, B23K 103/12, B82Y 30/00

(54) **VERFAHREN ZUM VERBINDEN VON ZWEI BAUTEILEN**
PROCESS TO JOIN TWO COMPONENTS
PROCÉDÉ POUR JOINDRE DEUX COMPOSANTS

(30) Priorität: 14.11.2017 DE 102017126724
(43) Veröffentlichungstag der Anmeldung: 23.09.2020
(73) Patentinhaber: NanoWired GmbH, 64579 Gernsheim (DE)
(72) Erfinder: WICKER, Sarah, 64283 Darmstadt (DE)
(74) Vertreter: Keenway Patentanwälte Neumann Heine Taruttis
(86) Internationale Anmeldenummer: PCT/EP2018/081036
(87) Internationale Veröffentlichungsnummer: WO 2019/096770

(56) Entgegenhaltungen:
- EP-A2- 1 100 297
- EP-A2- 1 583 146
- DE-A1-102006 031 322
- US-A1- 2009 256 255

## Beschreibung

Die vorliegende Erfindung betrifft Verfahren und ein Verbindungselement zum Verbinden eines ersten Bauteils mit einem zweiten Bauteil, insbesondere in Bezug auf Bauteile aus der Elektronik.

Bei den verschiedensten Anwendungen gibt es die Anforderung, Körper miteinander zu verbinden. Beispielsweise können zwei metallische Körper oder zwei Körper aus unterschiedlichen Materialien miteinander zu verbinden sein. Das ist insbesondere in der Elektronik der Fall. Zum Ausbilden derartiger Verbindungen sind aus dem Stand der Technik die unterschiedlichsten Verfahren bekannt. So sind insbesondere Verfahren bekannt, die zum Beispiel elektrische Leiter oder Körper aus Kupfer durch Schweißen, Hart- oder Weich-Löten, Kleben, Verschrauben, Vernieten oder Verprägen verbinden. Bei derartigen Verfahren werden präparierte Flächen präzise zueinander ausgerichtet und miteinander verbunden. Die zu verbindenden Körper müssen somit längentechnisch in Ihrer Ausdehnung und ihrem Verbindungsort eindeutig geometrisch bestimmt und vorbereitet sein. Weiterhin müssen im Vorfeld die Vorbereitungen zur Herstellung der Verbindung getroffen werden, wie zum Beispiel das Bohren von Löchern oder das Bereitstellen von entsprechenden Verbindungselementen. Die Verbindungstechniken des Verklebens, Verschraubens, Vernietens sind dabei Raumtemperaturprozesse. Schweißen, Weich- und Hartlöten sind hingegen heiße Prozesse, bei denen flüssiges Metall erzeugt wird, welches sich volumenfüllend und metallisch interagierend in die Fügestelle einfügt.

Verschweißen hat durch seinen erheblichen Temperatureintrag von regelmäßig bis zu 1400°C den Nachteil, dass es zum einen die betroffenen Körper im erheblichen Maße erhitzt, so dass eine Gefahr des Auslösens eines Brandes brennbarer Materialien entsteht. Auch kann es zu optischen Veränderungen der Oberfläche der zu verbindenden Körper kommen, was insbesondere bei vorbehandelten Oberflächen mit Lacken, Folien oder Beschichtungen problematisch sein kann. Außerdem sind viele Materialien nicht schweißfähig.

Hartlöten beispielsweise von Kupfer kann ebenfalls durch seinen erheblichen thermischen Energieeintrag zur Folge haben, dass sich die an der Verbindung beteiligten Komponenten erheblich (insbesondere über 400°C) erhitzen. Das kann dazu führen, dass entflammbare Materialien entzündet werden.

Weichlöten beispielsweise von Kupfer kann den Nachteil haben, dass einerseits die Scherfestigkeit der Verbindung geringer als erforderlich ist und andererseits, dass bei Weichloten Temperatur-Wechselbelastungen zur Entmischung des Metalls und damit zu einer Versprödung der Verbindung führen. Das kann zum Versagen der Verbindung führen. Weiterhin haben Weichlote den Nachteil, dass sie einen deutlich größeren Übergangswiderstand der Verbindung als beispielswiese reines Kupfer haben. Ein weiterer Nachteil von Weichlotverbindungen besteht in der geringen mechanischen Dauerfestigkeit, die regelmäßig nur bis etwa 120°C besteht. Auch ist die Korrosionsbeständigkeit einer derartigen Verbindung gegen saure Medien oft unzureichend.

Beim Verkleben von besonders leitfähigen Komponenten, wie zum Beispiel von Kupferkomponenten, besteht regelmäßig der Nachteil, dass der elektrische Übergangswiderstand durch die Klebung im erheblichen Maße negativ beeinflusst wird. Durch eine Leitklebung können die mechanischen Anforderungen an die mechanische Festigkeit der Verbindung nicht immer erfüllt werden. Auch besteht eine hinreichende mechanische Festigkeit regelmäßig nur bis zu einem Temperaturbereich von nur 120°C. Das kann insbesondere einen Einsatz in warmen oder heißen Umgebungen und/oder eine Verwendung heißer Medien unmöglich machen.

Beim Verschrauben und Vernieten müssen die Teile besonders präzise aneinandergefügt werden. Das benötigte Loch und der Aufbau durch die Schraube oder Nietverbindung führt regelmäßig weiterhin zu einer optischen Beeinträchtigung des optischen und mechanischen Erscheinungsbildes der Gesamtkonstruktion. Weiterhin muss konstruktiv sichergestellt werden, dass im Vorfeld bekannt ist, an welcher exakten Stelle die Verbindung erfolgen soll. Das kann die Verwendbarkeit von nicht-längendefinierten Bauteilen erschweren oder verhindern. Weiterhin besteht bei einer derartigen Verbindung regelmäßig ein Restspalt zwischen den Bauteilen. Durch Kapillarwirkung kann es zu einem Eintrag von Feuchtigkeit in den Restspalt und nachfolgend zu Korrosion kommen. Durch Korrosion kann die Verbindung beschädigt werden. Auch können ein elektrischer und/oder ein thermischer Übergangswiderstand der Verbindung ansteigen. Weiterhin kann ein Loch für eine Schraube oder Niete Undichtigkeiten im Bereich der Verbindung verursachen. Das kann den Einsatz einer solchen Verbindung beispielsweise für Gefäße oder Drucksysteme erschweren, insbesondere indem zusätzliche Dichtmittel benötigt werden.

Verfahren zum Verbinden zweier Bauteile über Nanostrukturen sind aus der DE 10 2006 031322 A1 und der EP 1 583 146 A2 bekannt.

Hiervon ausgehend ist es Aufgabe der hier vorliegenden Erfindung, die im Zusammenhang mit dem Stand der Technik geschilderten technischen Probleme zu lösen bzw. zumindest zu verringern. Es sollen insbesondere Verfahren und ein Verbindungselement zum Verbinden eines ersten Bauteils mit einem zweiten Bauteil vorgestellt werden, bei denen eine besonders stabile mechanische Verbindung, eine besonders gut elektrisch leitende Verbindung und/oder eine besonders gut thermisch leitende Verbindung zwischen den Bauteilen ausgebildet ist, die insbesondere auf besonders sichere und einfache Weise erhalten werden kann.

Diese Aufgaben werden gelöst mit Verfahren zum Verbinden eines ersten Bauteils, mit einem Verbindungselement gemäß den Merkmalen der unabhängigen Patentansprüche. Weitere vorteilhafte Ausgestaltungen sind in den jeweils abhängig formulierten Patentansprüchen angegeben. Die in den Patentansprüchen einzeln aufgeführten Merkmale sind in beliebiger, technologisch sinnvoller Weise miteinander kombinierbar und können durch erläuternde Sachverhalte aus der Beschreibung ergänzt werden, wobei weitere Ausführungsvarianten der Erfindung aufgezeigt werden.

Erfindungsgemäß wird ein Verfahren zum Verbinden eines ersten Bauteils mit einem zweiten Bauteil vorgestellt, das zumindest die folgenden Verfahrensschritte umfasst:
a) Bereitstellen einer Vielzahl von Nanodrähten auf einer ersten Kontaktfläche des ersten Bauteils nicht aber auf einer zweiten Kontaktfläche des zweiten Bauteils,
b) Zusammenführen des ersten Bauteils und des zweiten Bauteils, so dass die Vielzahl der Nanodrähte mit einer zweiten Kontaktfläche des zweiten Bauteils in Kontakt gebracht wird, und
c) Erwärmen zumindest der zweiten Kontaktfläche auf eine Temperatur von mindestens 150°C.

Bei dem ersten Bauteil und dem zweiten Bauteil handelt es sich vorzugsweise um elektronische Bauteile wie beispielsweise Halbleiterbauelemente, Computerchips, Mikroprozessoren oder Platinen. Das erste Bauteil und/oder das zweite Bauteil sind vorzugsweise zumindest teilweise elektrisch und/oder thermische leitend. Das beschriebene Verfahren ist allerdings nicht auf Anwendungen im Bereich der Elektronik beschränkt. So ist es beispielsweise auch möglich, ein Bauteil wie einen Sensor (als ein erstes Bauteil) gemäß dem beschriebenen Verfahren an einer Wand oder Halterung (als einem zweiten Bauteil) zu montieren. Durch das beschriebene Verfahren kann zwischen dem ersten Bauteil und dem zweiten Bauteil insbesondere eine mechanisch stabile, elektrisch leitende und/oder thermisch leitende Verbindung ausgebildet werden. Somit kann das beschriebene Verfahren in allen Bereichen angewendet werden, in denen eine Verbindung zwischen zwei Bauteilen mit einer oder mehreren dieser Eigenschaften erforderlich ist. Auch ist das beschriebene Verfahren nicht auf eine bestimmte Größe der Bauteile begrenzt. So eignet sich das beschriebene Verfahren beispielsweise für eine Anwendung im Bereich der (Mirko)elektronik oder zur Verbindung von deutlich größeren Bauteilen auf makroskopischer Ebene.

Die Bauteile werden über jeweilige Kontaktflächen miteinander verbunden. Bei einer Kontaktfläche handelt es sich insbesondere um einen räumlich ausgezeichneten Bereich einer Oberfläche des jeweiligen Bauteils. Insbesondere ist es bevorzugt, dass die Kontaktflächen durch Ausbildung der Verbindung ausgezeichnet werden. Das bedeutet, dass die Kontaktfläche sich zunächst nicht von der restlichen Oberfläche des Bauteils unterscheidet und erst durch Ausbilden der Verbindung derart hervortritt, dass die Kontaktfläche die Fläche ist, an der die Verbindung ausgebildet ist. In diesem Fall wird die Kontaktfläche gedanklich (d.h. ohne räumliche Auszeichnung) vom restlichen Teil der Oberfläche des Bauteils abgegrenzt. Beispielsweise kann eine Kontaktfläche eines flächigen elektrischen Leiters (als erstes Bauteil) dadurch ausgezeichnet werden, dass über eine begrenzte Fläche des flächigen Leiters (d.h. über die Kontaktfläche) eine flächige Verbindung zu einem zweiten elektrischen Leiter (als zweites Bauteil) ausgebildet wird.

Die Kontaktflächen sind vorzugsweise jeweils einfach zusammenhängende Bereiche der Oberfläche des jeweiligen Bauteils. Alternativ ist es möglich, dass die erste Kontaktfläche und/oder die zweite Kontaktfläche in mehrere voneinander getrennte Unterbereiche der Oberfläche des jeweiligen Bauteils unterteilt sind. So kann eine Kontaktfläche zwei oder mehr voneinander getrennte Abschnitte der Oberfläche des jeweiligen Bauteils umfassen.

Vorzugsweise sind die Bauteile starr ausgeführt oder weisen zumindest eine starre Oberfläche auf, an der die Kontaktflächen vorgesehen sind. Das bedeutet insbesondere, dass die Bauteile (oder zumindest die Kontaktflächen) nicht flexibel sind. Zwischen starren Bauteilen bzw. Kontaktflächen kann eine Verbindung nach dem beschriebenen Verfahren besonders gut ausgebildet werden. Wäre z.B. eines der Bauteile flexibel ausgeführt, so könnte es möglich sein, dass die Verbindung aufgrund einer Belastung der Nanodrähte bricht. In Abhängigkeit der genauen Umstände kann das beschriebene Verfahren aber auch mit flexiblen Bauteilen bzw. Kontaktflächen vorteilhaft eingesetzt werden.

Die Verbindung zwischen dem ersten Bauteil und dem zweiten Bauteil bzw. zwischen der ersten Kontaktfläche und der zweiten Kontaktfläche wird bei dem beschriebenen Verfahren über eine Vielzahl von Nanodrähten ausgebildet.

Unter einem Nanodraht (engl. "nanowire") wird hier jeder materielle Körper verstanden, der eine drahtähnliche Form und eine Größe im Bereich von wenigen Nanometern bis zu wenigen Mikrometern hat. Ein Nanodraht kann z.B. eine kreisförmige, ovale oder mehreckige Grundfläche aufweisen. Insbesondere kann ein Nanodraht eine hexagonale Grundfläche aufweisen. Vorzugsweise sind alle an der Verbindung beteiligten Nanodrähte aus dem gleichen Material gebildet. Besonders bevorzugt ist es, dass die Nanodrähte vollständig aus einem elektrisch leitenden Material gebildet sind.

Bevorzugt weisen die Nanodrähte eine Länge im Bereich von 100 nm [Nanometer] bis 100 µm [Mikrometer], insbesondere im Bereich von 500 nm bis 30 µm auf. Weiterhin weisen die Nanodrähte bevorzugt einen Durchmesser im Bereich von 10 nm bis 10 µm, insbesondere im Bereich von 30 nm bis 2 µm auf. Dabei bezieht sich der Begriff Durchmesser auf eine kreisförmige Grundfläche, wobei bei einer davon abweichenden Grundfläche eine vergleichbare Definition eines Durchmessers heranzuziehen ist. Es ist besonders bevorzugt, dass alle verwendeten Nanodrähte die gleiche Länge und den gleichen Durchmesser aufweisen.

Die Verbindung wird vorzugsweise dadurch ausgebildet, dass zwischen den jeweiligen zu verbindenden Kontaktflächen die Vielzahl der Nanodrähte vorgesehen wird. Aufgrund der Größe der Nanodrähte im Nanometer-Bereich ist die Oberfläche der Verbindung (d.h. die Fläche, über die Kräfte wie die Van-der-Waals-Kraft auf atomarer Ebene wirken) besonders groß. Damit kann die Verbindung besonders gut elektrisch leitend, thermisch leitend und/oder mechanisch stabil sein. Für eine elektrisch und/oder thermische besonders gut leitende Verbindung ist es bevorzugt, dass die Nanodrähte aus einem elektrisch und/oder thermisch leitenden Material gebildet sind. Besonders bevorzugt ist hier die Verwendung von Kupfer. Auch die Kontaktflächen sind vorzugsweise aus einem elektrisch und/oder thermisch leitenden Material gebildet, insbesondere mit Kupfer. Wie weiter oben beschrieben, ist die Verwendung von Kupfer insbesondere bei Schweißverbindungen nicht möglich. Aufgrund der großen Oberfläche der durch das beschriebene Verfahren erhaltenen Verbindung kann nicht nur eine elektrische, sondern auch eine thermische Leitfähigkeit der Verbindung besonders groß sein. Dies kann beispielsweise die Kühlung der an der Verbindung beteiligten Bauteile verbessern. Insbesondere dazu ist die Verwendung von Kupfer für die Nanodrähte und/oder für die Kontaktflächen bevorzugt.

Die beschriebene Verbindung kann weiterhin besonders einfach und ohne Werkzeug ausgebildet werden. Es müssen lediglich die zu verbindenden Kontaktflächen aneinander geführt und in begrenztem Maße erwärmt werden. Ein Druck kann optional ausgeübt werden, ist aber nicht zwingend erforderlich.

In Schritt a) des beschriebenen Verfahrens wird eine Vielzahl von Nanodrähten auf der ersten Kontaktfläche und damit auf zumindest einem Teil der Oberfläche des ersten Bauteils bereitgestellt. Das kann insbesondere durch galvanisches Wachstum der Nanodrähte erfolgen. Unter Bereitstellen ist dabei einerseits zu verstehen, dass die Nanodrähte als Teil des Verfahrens auf die erste Kontaktfläche aufgebracht werden. Andererseits umfasst das Bereitstellen aber auch, dass ein erste Bauteil verwendet wird, auf dem die Nanodrähte bereits an der ersten Kontaktfläche vorgesehen sind. So kann beispielsweise ein entsprechend vorbereitetes erstes Bauteil von einem Zulieferer bezogen und für die Verwendung des beschriebenen Verfahrens genutzt werden. Auch ein derartiges Beziehen eines vorbereiteten Bauteils ist ein Bereitstellen der Nanodrähte im hier verwendeten Sinne. Das beschriebene Verfahren hat insbesondere den Vorteil, dass die Nanodrähte nur auf einer der beteiligten Kontaktflächen bereitgestellt werden müssen und nicht auf beiden. Es ist daher bevorzugt, dass die Nanodrähte nur auf der ersten Kontaktfläche, nicht aber auf der zweiten Kontaktfläche bereitgestellt werden.

Die Nanodrähte werden vorzugsweise derart auf der ersten Kontaktfläche bereitgestellt, dass diese im Wesentlichen senkrecht (vorzugsweise senkrecht) auf der ersten Kontaktfläche stehen. Die Gesamtheit der gemäß Schritt a) bereitgestellten Nanodrähte kann insbesondere als ein Rasen von Nanodrähten bezeichnet werden. Die Nanodrähte können aber auch in beliebiger Orientierung auf der ersten Kontaktfläche bereitgestellt werden. Auch ist es möglich, dass eine Kontaktfläche in eine Mehrzahl von (miteinander verbundenen oder voneinander getrennten) Teilbereiche unterteilt ist, wobei die Nanodrähte in den verschiedenen Teilbereichen verschieden orientiert sind. Damit kann eine besonders stabile Verbindung realisiert werden, die insbesondere auch Scherkräften besonders gut standhalten kann. Weiterhin ist es möglich, dass die Nanodrähte an verschiedenen Stellen der ersten Kontaktfläche verschieden ausgeführt sind, insbesondere hinsichtlich deren Länge, Durchmesser, Material und Dichte (wobei die Dichte der Nanodrähte angibt, wie viele Nanodrähte pro Fläche vorgesehen sind).

In Schritt b) des beschriebenen Verfahrens werden die Bauteile bzw. die Kontaktflächen zusammengeführt, also aufeinander zu bewegt. Die Nanodrähte auf der ersten Kontaktfläche kommen dadurch mit der zweiten Kontaktfläche in Kontakt. Die Verbindung zwischen dem ersten Bauteil und dem zweiten Bauteil kann durch Schritt b) bereits teilweise ausgebildet werden.

Die endgültige Ausbildung der Verbindung erfolgt aber erst in Schritt c) des beschriebenen Verfahrens. Darin wird zumindest die zweite Kontaktfläche auf eine Temperatur von mindestens 150°C (als Mindesttemperatur), vorzugsweise auf eine Temperatur von mindestens 170°C (als Mindesttemperatur) erwärmt. Vorzugsweise liegt die Temperatur bei 200°C.

Durch diese Erwärmung verbinden sich die Nanodrähte mit der zweiten Kontaktfläche. Entsprechend genügt es, dass nur die zweite Kontaktfläche erwärmt wird. Praktisch ist bei einer derartigen Erwärmung regelmäßig nicht zu unterschieden, ob die erste Kontaktfläche, die zweite Kontaktfläche, die Nanodrähte, das erste Bauteil teilweise oder insgesamt und/oder das zweite Bauteil teilweise oder insgesamt erwärmt werden. Das ist insbesondere der Fall, wenn thermisch leitende Materialien verwendet werden. Für die Ausbildung der Verbindung ist ein (Mit-)Erwärmen von anderen Komponenten als der zweiten Kontaktfläche nicht erforderlich, aber auch nicht hinderlich. Somit kann das Erwärmen gemäß Schritt c) insbesondere dadurch erfolgen, dass das erste Bauteil und das zweite Bauteil insgesamt erwärmt werden, beispielsweise in einem Ofen. Alternativ ist es aber auch möglich, lokal Wärme in den Bereich der Verbindung, insbesondere in den Bereich der zweiten Kontaktfläche einzutragen.

Für das Ausbilden der Verbindung kann es ausreichen, dass die beschriebene Mindesttemperatur einmalig zumindest kurzzeitig erreicht wird. Ein Halten der Mindesttemperatur ist nicht erforderlich. Es ist aber bevorzugt, dass die Temperatur, in der gemäß Schritt c) erwärmt wird, für mindestens zehn Sekunden, vorzugsweise mindestens 30 Sekunden gehalten wird. Damit kann sichergegangen werden, dass die Verbindung wie gewünscht ausgebildet wird. Ein längeres Halten der Temperatur ist grundsätzlich nicht schädlich.

Die Verbindung wird dadurch ausgebildet, dass sich die Nanodrähte, insbesondere deren der zweiten Kontaktfläche zugewandten Enden, mit der zweiten Kontaktfläche verbinden. Diese Verbindung wird auf atomarer Ebene ausgebildet. Der dabei atomar ablaufende Vorgang ist dem beim Sintern ablaufenden ähnlich. Die erhaltene Verbindung kann insbesondere derart dicht für Gase und/oder Flüssigkeiten sein, dass eine Korrosion der Verbindung und/oder der miteinander verbundenen Bauteile im Bereich der Verbindung verhindert oder zumindest eingeschränkt werden kann. Insbesondere kann die ausgebildete Verbindung als vollmetallisch betrachtet werden. Das beschriebene Verfahren kann auch als "Klett-Welding" bezeichnet werden. Damit wird zum Ausdruck gebracht, dass die Verbindung durch eine Vielzahl von Nanodrähten und damit durch eine Vielzahl von länglichen, haarähnlichen Strukturen und durch Erwärmen erhalten wird. Durch die Vielzahl der Nanodrähte können Unebenheiten und Rauigkeiten der Kontaktflächen ausgeglichen werden.

Die Verfahrensschritte a) bis c) werden vorzugsweise in der angegebenen Reihenfolge, insbesondere nacheinander durchgeführt. Insbesondere wird Schritt a) vorzugsweise vor Beginn der Schritte b) und c) durchgeführt. Die Schritte b) und c) können aber auch zumindest teilweise zeitlich überlappend durchgeführt werden. So kann beispielsweise vor oder während Schritt b) ein Vorwärmen erfolgen, das als Teil von Schritt c) aufgefasst werden kann. Es ist auch möglich, die zweite Kontaktfläche vor Schritt b) derart zu erwärmen, dass die zum Ausbilden der Verbindung erforderliche Temperatur bereits beim Zusammenführen gemäß Schritt b) erreicht ist. Insbesondere insoweit kann Schritt c) also auch vor Schritt b) beginnen. In dem Fall wird Schritt c) insoweit durchgeführt, als dass die gemäß Schritt c) erforderliche Temperatur zumindest zeitweise auch nach Abschluss von Schritt b) vorliegt.

Als ein weiterer Aspekt wird ein Verfahren zum Verbinden eines ersten Bauteils mit einem zweiten Bauteil vorgestellt, das zumindest die folgenden Verfahrensschritte umfasst:
A) Bereitstellen eines Verbindungselements mit einer Vielzahl von Nanodrähten auf einer ersten Verbindungsfläche und auf einer zweiten Verbindungsfläche,
B) Zusammenführen einer ersten Kontaktfläch des ersten Bauteils mit der ersten Verbindungsfläche des Verbindungselements,
C) Zusammenführen einer zweiten Kontaktfläche des zweiten Bauteils mit der zweiten Verbindungsfläche des Verbindungselements,
D) Erwärmen zumindest der ersten Kontaktfläche und der zweiten Kontaktfläche auf eine Temperatur von mindestens 150°C.

Die für das zuvor beschriebene Verfahren (umfassend die Schritte a) bis c)) beschriebenen besonderen Vorteile und Ausgestaltungsmerkmale sind auf das vorliegend beschriebene Verfahren (umfassend die Schritte A) bis D)) anwendbar und übertragbar, und umgekehrt.

Mit dem zuvor beschriebenen Verfahren können zwei Bauteile unmittelbar miteinander verbunden werden. Dabei werden gemäß Schritt a) Nanodrähte auf einem der Bauteile bereitgestellt. Bei dem vorliegend beschriebenen Verfahren hingegen werden die Bauteile mittelbar über das Verbindungselement miteinander verbunden. Das hat den Vorteil, dass auf keinem der Bauteile Nanodrähte bereitgestellt werden müssen. Es genügt, dass die Nanodrähte auf dem Verbindungselement vorhanden sind. Insbesondere ist es bevorzugt, dass auf der ersten Kontaktfläche und auf der zweiten Kontaktfläche keine Nanodrähte bereitgestellt werden, sondem nur auf dem Verbindungselement. Das kann die Durchführung des Verfahrens erleichtern und insbesondere auch den Anwendungsbereich des Verfahrens auf solche Bauteile erweitern, die einem Wachstum der Nanodrähte nicht oder nur schlecht zugänglich sind. Ferner kann das Wachstum der Nanodrähte lokal von den Bauteilen getrennt erfolgen.

In Schritt A) wird ein Verbindungselement bereitgestellt, das zwei Verbindungsflächen aufweist. Beide Verbindungsflächen weisen jeweils eine Vielzahl von Nanodrähten auf.

Das Verbindungselement kann insbesondere als ein Mittler der Verbindung zwischen dem ersten Bauteil und dem zweiten Bauteil aufgefasst werden. Als Verbindungselement kommt insbesondere jeder körperliche Gegenstand in Betracht, der geeignet ist, zwischen der ersten Kontaktfläche des ersten Bauteils und der zweiten Kontaktfläche des zweiten Bauteils angeordnet zu werden.

Bei einer Verbindungsfläche handelt es sich insbesondere um einen räumlich ausgezeichneten Bereich einer Oberfläche des Verbindungselements. Insbesondere ist es bevorzugt, dass die Verbindungsflächen durch Ausbildung der Verbindung ausgezeichnet werden. Das bedeutet, dass die Verbindungsfläche sich zunächst nicht von der restlichen Oberfläche des Verbindungselements unterscheidet und erst durch Ausbilden der Verbindung derart hervortritt, dass die Verbindungsfläche die Fläche ist, an der die Verbindung ausgebildet ist. In diesem Fall wird die Verbindungsfläche gedanklich (d.h. ohne räumliche Auszeichnung) vom restlichen Teil der Oberfläche des Verbindungselements abgegrenzt. Beispielsweise kann eine Verbindungsfläche eines flächigen Verbindungselements dadurch ausgezeichnet werden, dass über eine begrenzte Fläche des Verbindungselements (d.h. über die Verbindungsfläche) eine flächige Verbindung zu dem jeweiligen Bauteil ausgebildet wird.

Die Verbindungsfläche ist vorzugsweise so groß wie die entsprechende Kontaktfläche und weist insbesondere vorzugsweise deren Form auf. Es ist aber auch möglich, dass die Kontaktfläche größer oder kleiner ist als die entsprechende Verbindungsfläche und/oder dass die die Kontaktfläche und die entsprechende Verbindungsfläche unterschiedliche Formen aufweisen.

Die Verbindungsflächen sind vorzugsweise jeweils einfach zusammenhängende Bereiche der Oberfläche des Verbindungselements. Alternativ ist es möglich, dass die erste Verbindungsfläche und/oder die zweite Verbindungsflächen in mehrere voneinander getrennte Unterbereiche der Oberfläche des Verbindungselements unterteilt sind. So kann eine Verbindungsfläche zwei oder mehr voneinander getrennte Abschnitte der Oberfläche des Verbindungselements umfassen. In dem Fall erfolgt eine Zuordnung eines Abschnitts zur ersten Verbindungsfläche bzw. zur zweiten Verbindungsfläche danach, ob die Verbindungsfläche zum Ausbilden der Verbindung zur ersten Kontaktfläche bzw. zur zweiten Kontaktfläche bestimmt ist bzw. verwendet wurde.

In den Schritten B) und C) werden die erste Kontaktfläche mit der ersten Verbindungsfläche bzw. die zweite Kontaktfläche mit der zweiten Verbindungsfläche zusammengeführt.

Die Verfahrensschritte A) bis D) werden vorzugsweise in der angegebenen Reihenfolge, insbesondere nacheinander durchgeführt. Insbesondere wird Schritt A) vorzugsweise vor Beginn der Schritte B) bis D) durchgeführt.

Die Schritte B) und C) können gleichzeig, zeitlich überlappend oder nacheinander durchgeführt werden.

Werden die Schritte B) und C) nacheinander durchgeführt, erfolgt das Zusammenführen hier entsprechend dem Zusammenführen gemäß Schritt b) des zuvor beschriebenen Verfahrens. So kann zunächst die erste Kontaktfläche mit der ersten Verbindungsfläche, also das erste Bauteil mit dem Verbindungselement, zusammengeführt werden (Schritt B)). Anschließend kann das gemäß Schritt B) mit dem ersten Bauteil zusammengeführte Verbindungselement derart mit dem zweiten Bauteil zusammengeführt werden, dass die zweite Kontaktfläche und die zweite Verbindungsfläche zusammengeführt werden (Schritt C)).

Die Schritte B) und C) können beispielsweise dadurch gleichzeitig oder zeitlich überlappend durchgeführt werden, dass das Verbindungselement zwischen den beiden Bauteilen gehalten wird und diese gleichzeitig von beiden Seiten auf das Verbindungselement hinbewegt werden.

In Schritt D) werden zumindest die erste Kontaktfläche und die zweite Kontaktfläche erwärmt. Dies erfolgt entsprechend der Erwärmung gemäß Schritt c) des zuvor beschriebenen Verfahrens, wobei hier auch die erste Kontaktfläche erwärmt wird. Das Verbindungselement kann bei dem Erwärmen miterwärmt werden. Das ist zwar nicht erforderlich, kann aber praktisch leichter sein bzw. kann unvermeidlich sein.

Die Schritte B) und C) sowie der Schritt D) können zumindest teilweise zeitlich überlappend durchgeführt werden. So kann beispielsweise vor oder während der Schritte B) und C) ein Vorwärmen erfolgen, das als Teil von Schritt D) aufgefasst werden kann. Es ist auch möglich, die erste Kontaktfläche und/oder die zweite Kontaktfläche vor Schritt D) derart zu erwärmen, dass die zum Ausbilden der Verbindung erforderliche Temperatur bereits beim Zusammenführen gemäß Schritt B) bzw. C) erreicht ist. Insbesondere insoweit kann Schritt D) also auch vor Schritt B) bzw. C) beginnen. In dem Fall wird Schritt D) insoweit durchgeführt, als dass die gemäß Schritt D) erforderliche Temperatur zumindest zeitweise auch nach Abschluss von Schritt B) bzw. C) vorliegt.

Das vorliegend beschriebene Verfahren (umfassend die Schritte A) bis D)) kann als eine zweifache Durchführung des zuvor beschriebenen Verfahrens (umfassend die Schritte a) bis c)) aufgefasst werden. So kann in einem ersten Schritt a) eine Vielzahl von Nanodrähten auf einer ersten Verbindungsfläche (die hier als erste Kontaktfläche aufgefasst wird) des Verbindungselements (das hier als erstes Bauteil aufgefasst wird) bereitgestellt werden. In einem zweiten Schritt a) kann eine Vielzahl von Nanodrähten auf einer zweiten Verbindungsfläche (die hier ebenfalls als eine erste Kontaktfläche aufgefasst wird) des Verbindungselements (das hier als erstes Bauteil aufgefasst wird) bereitgestellt werden. Beide Schritte a) zusammen bilden Schritt A). Das Verbindungselement kann mit einem ersten Bauteil gemäß einem ersten Schritt b) und mit einem zweiten Bauteil gemäß einem zweiten Schritt b) zusammengeführt werden. Das sind die Schritte B) und C). Zudem erfolgt ein Erwärmen gemäß Schritt c) bzw. D). Die beschriebene zweifache Durchführung der Schritte a) und b) kann dabei in verschiedenen Reihenfolgen erfolgen. So kann beispielsweise zuerst der erste und zweite Schritt a), anschließend der erste und zweite Schritt b) und anschließend der Schritt c) durchgeführt werden. Es ist aber auch möglich, beispielswiese zunächst den ersten Schritt a), anschließend den ersten Schritt b) und schließlich ein Erwärmen entsprechend einem ersten Schritt c) durchzuführen. Dabei können die Nanodrähte auf der zweiten Verbindungsfläche beispielsweise durch einen Schutzlack geschützt werden. Anschließend kann der Schutzlack entfernt werden und der zweite Schritt a), anschließend der zweite Schritt b) und anschließend erneut ein Erwärmen entsprechend einem zweiten Schritt c) durchgeführt werden.

Die im Folgenden beschriebenen bevorzugten Ausführungsformen beziehen sich sowohl auf das zuerst beschriebene Verfahren (umfassend die Schritte a) bis c)) als auch auf das anschließend beschriebene Verfahren (umfassend die Schritte A) bis D)).

In einer bevorzugten Ausführungsform des Verfahrens erfolgt die Erwärmung auf eine Temperatur von maximal 270°C, insbesondere von maximal 240°C.

Mit den beschriebenen Verfahren kann eine Verbindung zwischen zwei Bauteilen erhalten werden, ohne dass eine Temperatur in einer Höhe wie etwa beim Schweißen oder Hartlöten auftritt. In der vorliegenden Ausführungsform kann dieser Vorteil dadurch ausgenutzt werden, dass auf eine Erwärmung in einem nicht erforderlichen Umfang verzichtet wird. Somit können Schäden beispielsweise an den Bauteilen vermieden werden. Auch kann ein Entflammen von brennbaren Materialien durch die beschriebenen niedrigen Temperaturen ausgeschlossen werden. Es ist entsprechend insbesondere bevorzugt, dass zu keinem Zeitpunkt der beschriebenen Verfahren eine Temperatur des ersten Bauteils und/oder des zweiten Bauteils 270°C, insbesondere 240°C übersteigt.

In einer weiteren bevorzugten Ausführungsform des Verfahrens werden das erste Bauteil und das zweite Bauteil zumindest während eines Teils der Erwärmung mit einem Druck von mindestens 10 MPa, insbesondere mindestens 15 MPa, und/oder von höchstens 100 MPa, insbesondere von 70 MPa, aufeinander zu gedrückt.

Vorzugsweise liegt der verwendete Druck im Bereich von 10 MPA und 100 MPa, insbesondere im Bereich von 15 MPa und 70 MPa. Besonders bevorzugt ist ein Druck von 20 MPa.

Vorzugsweise liegt der Druck oberhalb der angegebenen unteren Grenze zumindest in einem Zeitabschnitt vor, in dem die Temperatur die dafür genannte untere Grenze überschreitet. Insoweit werden also die Nanodrähte und die Kontaktfläche zumindest in diesem Zeitabschnitt sowohl einem entsprechenden Druck als auch einer entsprechenden Temperatur ausgesetzt. Dadurch kann die Verbindung durch Einwirkung von Druck und Temperatur ausgebildet werden.

In einer weiteren bevorzugten Ausführungsform des Verfahrens sind die erste Verbindungsfläche und die zweite Verbindungsfläche einander gegenüberliegend ausgebildet.

Bevorzugt sind die erste Verbindungsfläche und die zweite Verbindungsfläche parallel zueinander angeordnet.

In der vorliegenden Ausführungsform kann das Verbindungselement zwischen zwei zu verbindenden Bauteilen angeordnet werden. Dabei bewirkt das Verbindungselement (abgesehen von der Ausbildung der Verbindung) lediglich, dass die erste Kontaktfläche und die zweite Kontaktfläche nicht unmittelbar aneinander anliegend, sondern insbesondere um die Materialstärke des Verbindungselements voneinander beabstandet angeordnet werden. Eine Orientierung der ersten Kontaktfläche und der zweiten Kontaktfläche relativ zueinander bleibt von dem Verbindungselement unbeeinflusst.

Alternativ können die erste Verbindungsfläche und die zweite Verbindungsfläche beispielsweise auch an verschiedenen Stellen einer insbesondere planaren Oberfläche des Verbindungselements vorgesehen sein. In dem Fall kann das erste Bauteil an einer ersten dieser Stellen und das zweite Bauteil an einer zweiten dieser Stellen mit dem Verbindungselement verbunden werden.

Als ein weiterer Aspekt wird ein Verbindungselement zum Verbinden eines ersten Bauteils mit einem zweiten Bauteil, insbesondere gemäß dem beschriebenen Verfahren umfassend die Schritte A) bis D), vorgestellt, wobei das Verbindungselement an einer ersten Verbindungsfläche und an einer zweiten Verbindungsfläche jeweils eine Vielzahl von Nanodrähten aufweist.

Die weiter oben beschriebenen besonderen Vorteile und Ausgestaltungsmerkmale des Verfahrens umfassend die Schritte A) bis D) sind auf das beschriebene Verbindungselement anwendbar und übertragbar, und umgekehrt.

In einer bevorzugten Ausführungsform ist das Verbindungselement bandförmig ausgebildet und weist zwei gegenüberliegende Bandoberflächen auf, wobei die erste Verbindungsfläche auf einer ersten der Bandoberflächen und die zweite Verbindungsfläche auf einer zweiten der Bandoberflächen ausgebildet ist.

Die gegenüberliegenden Bandoberflächen sind die beiden Oberflächen des Bandes, die gegenüber allen anderen Oberflächen (die sich aufgrund der Materialstärke des Bandes ergeben) einen erheblich größeren Flächeninhalt aufweisen. Vorzugsweise liegt eine Materialstärke des Bandes im Bereich von 0,05 mm und 5 mm [Millimeter], insbesondere im Bereich von 0,1 mm und 1 mm.

Das Bandmaterial kann beispielsweise als eine Rolle bereitgestellt werden. Die Nanodrähte können dabei bereits auf dem Bandmaterial vorgesehen sein und beispielsweise durch einen Schutzlack geschützt werden. Vor Verwendung des Verbindungselements können der Schutzlack entfernt und die Nanodrähte so freigelegt werden. Ein jeweils benötigter Teil des Bandmaterials kann zur Verwendung von der Rolle abgetrennt werden.

In der vorliegenden Ausführungsform kann das Verbindungselement auch als ein "Verbindungstape" und insbesondere als ein "Klett-Welding-Tape" bezeichnet werden.

In einer weiteren bevorzugten Ausführungsform ist das Verbindungselements zumindest teilweise elektrisch und/oder thermisch leitfähig.

Insbesondere in dieser Ausführungsform kann die ausgebildete Verbindung besonders gut elektrisch und/oder thermisch leitfähig sein.

Eine elektrische und/oder thermische Leitfähigkeit im hier verwendeten Sinne liegt insbesondere bei Metallen wie beispielsweise Kupfer vor, die allgemein als "elektrisch leitfähig" bzw. "thermisch leitfähig" bezeichnet werden. Insbesondere sollen allgemein als elektrisch bzw. thermisch isolierend betrachtete Materialien hier nicht als elektrisch bzw. thermisch leitfähig angesehen werden.

Die Erfindung und das technische Umfeld werden nachfolgend anhand der Figuren näher erläutert. Die Figuren zeigen besonders bevorzugte Ausführungsbeispiele, auf die die Erfindung jedoch nicht begrenzt ist. Insbesondere ist darauf hinzuweisen, dass die Figuren und insbesondere die dargestellten Größenverhältnisse nur schematisch sind. Es zeigen schematisch:
- Fig. 1:: eine schematische Darstellung eines ersten Verfahrens zum Verbinden zweier Bauteile,
- Fig. 2:: eine schematische Darstellung einer Anordnung von zwei gemäß dem Verfahren aus Fig. 1 miteinander verbundenen Bauteilen, und
- Fig. 3:: eine schematische Darstellung eines zweiten Verfahrens zum Verbinden zweier Bauteile,
- Fig. 4:: eine schematische Darstellung einer Anordnung von zwei gemäß dem Verfahren aus Fig. 3 miteinander verbundenen Bauteilen.

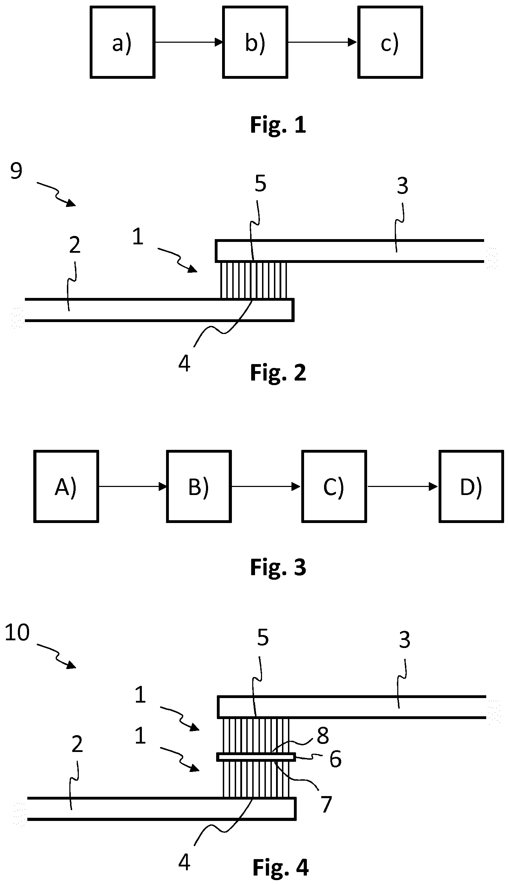

Fig. 1 und zeigt ein erstes Verfahren zum Verbinden eines ersten Bauteils 2 mit einem zweiten Bauteil 3. Eine dabei erhaltene erste Anordnung 9 ist in Fig. 2 gezeigt. Das Verfahren gemäß Fig. 1 wird unter Verwendung der Bezugszeichen aus Fig. 2 beschrieben.

Das Verfahren gemäß Fig. 1 umfasst die folgenden Verfahrensschritte:
a) Bereitstellen einer Vielzahl von Nanodrähten 1 auf einer ersten Kontaktfläche 4 des ersten Bauteils 2,
b) Zusammenführen des ersten Bauteils 2 und des zweiten Bauteils 3, so dass die Vielzahl der Nanodrähte 1 mit einer zweiten Kontaktfläche 5 des zweiten Bauteils 3 in Kontakt gebracht wird, und
c) Erwärmen zumindest der zweiten Kontaktfläche 5 auf eine Temperatur von mindestens 150°C.

Fig. 3 und zeigt ein zweites Verfahren zum Verbinden eines ersten Bauteils 2 mit einem zweiten Bauteil 3. Eine dabei erhaltene zweite Anordnung 10 ist in Fig. 4 gezeigt. Das Verfahren gemäß Fig. 3 wird unter Verwendung der Bezugszeichen aus Fig. 4 beschrieben.

Das Verfahren gemäß Fig. 3 umfasst die folgenden Verfahrensschritte:
A) Bereitstellen eines Verbindungselements 6 mit einer Vielzahl von Nanodrähten 1 auf einer ersten Verbindungsfläche 7 und auf einer zweiten Verbindungsfläche 8,
B) Zusammenführen einer ersten Kontaktfläche 4 des ersten Bauteils 2 mit der ersten Verbindungsfläche 7 des Verbindungselements 6,
C) Zusammenführen einer zweiten Kontaktfläche 5 des zweiten Bauteils 3 mit der zweiten Verbindungsfläche 8 des Verbindungselements 6,
D) Erwärmen zumindest der ersten Kontaktfläche 4 und der zweiten Kontaktfläche 5 auf eine Temperatur von mindestens 150°C.

### Bezugszeichenliste

- 1: Nanodraht
- 2: erstes Bauteil
- 3: zweites Bauteil
- 4: erste Kontaktfläche
- 5: zweite Kontaktfläche
- 6: Verbindungselement
- 7: erste Verbindungsfläche
- 8: zweite Verbindungsfläche
- 9: erste Anordnung
- 10: zweite Anordnung

## Patentansprüche

1. Verfahren zum Verbinden eines ersten Bauteils (2) mit einem zweiten Bauteil (3) umfassend zumindest die folgenden Verfahrensschritte:
a) Bereitstellen einer Vielzahl von Nanodrähten (1) auf einer ersten Kontaktfläche (4) des ersten Bauteils (2), nicht aber auf einer zweiten Kontaktfläche (5) des zweiten Bauteils (3),
b) Zusammenführen des ersten Bauteils (2) und des zweiten Bauteils (3), so dass die Vielzahl der Nanodrähte (1) mit der zweiten Kontaktfläche (5) des zweiten Bauteils (3) in Kontakt gebracht wird, und
c) Erwärmen zumindest der zweiten Kontaktfläche (5) auf eine Temperatur von mindestens 150°C.

2. Verfahren zum Verbinden eines ersten Bauteils (2) mit einem zweiten Bauteil (3) umfassend zumindest die folgenden Verfahrensschritte:
A) Bereitstellen eines Verbindungselements (6) mit einer Vielzahl von Nanodrähten (1) auf einer ersten Verbindungsfläche (7) und auf einer zweiten Verbindungsfläche (8),
B) Zusammenführen einer ersten Kontaktfläche (4) des ersten Bauteils (2) mit der ersten Verbindungsfläche (7) des Verbindungselements (6),
C) Zusammenführen einer zweiten Kontaktfläche (5) des zweiten Bauteils (3) mit der zweiten Verbindungsfläche (8) des Verbindungselements (6),
D) Erwärmen zumindest der ersten Kontaktfläche (4) und der zweiten Kontaktfläche (5) auf eine Temperatur von mindestens 150°C.

3. Verfahren nach einem der vorhergehenden Ansprüche, wobei die Erwärmung auf eine Temperatur von maximal 270°C erfolgt.

4. Verfahren nach einem der vorhergehenden Ansprüche, wobei das erste Bauteil (2) und das zweite Bauteil (3) zumindest während eines Teils der Erwärmung mit einem Druck von mindestens 10 MPa und/oder von höchstens 100 MPa aufeinander zu gedrückt werden.

5. Verfahren nach einem der vorhergehenden Ansprüche, wobei die erste Verbindungsfläche (7) und die zweite Verbindungsfläche (8) einander gegenüberliegend ausgebildet sind.

## Claims

1. Method for connecting a first component (2) to a second component (3) comprising at least the following method steps:
a) providing a plurality of nanowires (1) on a first contact surface (4) of the first component (2), but not on a second contact surface (5) of the second component (3),
b) bringing the first component (2) and the second component (3) together so that the plurality of nanowires (1) are brought into contact with the second contact surface (5) of the second component (3), and
c) heating at least the second contact surface (5) to a temperature of at least 150°C.

2. Method for connecting a first component (2) to a second component (3) comprising at least the following method steps:
A) providing a connecting element (6) having a plurality of nanowires (1) on a first connecting surface (7) and on a second connecting surface (8),
B) bringing a first contact surface (4) of the first component (2) together with the first connecting surface (7) of the connecting element (6),
C) bringing a second contact surface (5) of the second component (3) together with the second connecting surface (8) of the connecting element (6),
D) heating at least the first contact surface (4) and the second contact surface (5) to a temperature of at least 150°C.

3. Method according to one of the preceding claims, the heating taking place to a maximum temperature of 270°C.

4. Method according to one of the preceding claims, the first component (2) and the second component (3) being pressed onto one another with a pressure of at least 10 MPa and/or of at most 100 MPa, at least during part of the heating.

5. Method according to one of the preceding claims, the first connecting surface (7) and the second connecting surface (8) being formed lying opposite one another.

## Revendications

1. Procédé de liaison d'un premier composant (2) à un deuxième composant (3), comprenant au moins les étapes de procédé suivantes :
a) la fourniture d'une pluralité de nanofils (1) sur une première surface de contact (4) du premier composant (2), mais pas sur une deuxième surface de contact (5) du deuxième composant (3),
b) la réunion du premier composant (2) et du deuxième composant (3) de telle sorte que la pluralité de nanofils (1) est amenée en contact avec la deuxième surface de contact (5) du deuxième composant (3), et
c) le chauffage d'au moins la deuxième surface de contact (5) à une température d'au moins 150 °C.

2. Procédé de liaison d'un premier composant (2) à un deuxième composant (3), comprenant au moins les étapes de procédé suivantes :
A) la fourniture d'un élément de liaison (6) avec une pluralité de nanofils (1) sur une première surface de liaison (7) et sur une deuxième surface de liaison (8),
B) la réunion d'une première surface de contact (4) du premier composant (2) avec la première surface de liaison (7) de l'élément de liaison (6),
C) la réunion d'une deuxième surface de contact (5) du deuxième composant (3) avec la deuxième surface de liaison (8) de l'élément de liaison (6),
D) le chauffage d'au moins la première surface de contact (4) et la deuxième surface de contact (5) à une température d'au moins 150 °C.

3. Procédé selon l'une quelconque des revendications précédentes, dans lequel le chauffage est effectué à une température de 270 °C au maximum.

4. Procédé selon l'une quelconque des revendications précédentes, dans lequel le premier composant (2) et le deuxième composant (3) sont pressés l'un vers l'autre, au moins pendant une partie du chauffage, avec une pression d'au moins 10 MPa et/ou d'au plus 100 MPa.

5. Procédé selon l'une quelconque des revendications précédentes, dans lequel la première surface de liaison (7) et la deuxième surface de liaison (8) sont réalisées en opposition l'une par rapport à l'autre.
